# EUROPÄISCHE PATENTSCHRIFT

(11) **EP 0 308 715 B1**
(45) Veröffentlichungstag und Bekanntmachung des Hinweises auf die Patenterteilung: **17.03.1993**
(21) Anmeldenummer: 88114511.4
(22) Anmeldetag: 06.09.1988
(51) Int. Cl.: H05K 7/18

(54) **Schaltschrank**
Electrical cabinet
Armoire électrique

(30) Priorität: 19.09.1987 DE 3731547
(43) Veröffentlichungstag der Anmeldung: 29.03.1989
(73) Patentinhaber: Rittal-Werk Rudolf Loh GmbH & Co. KG, 35745 Herborn (DE)
(72) Erfinder: Debus, Jürgen, D-6344 Dietzhölztal 1 (DE); Koch, Hans-Georg, D-6344 Dietzhölztal 1 (DE); Zachrei, Jürgen, D-6340 Dillenburg 8 (DE); Bütergerds, Helmut, D-6345 Eschenburg 1 (DE)
(74) Vertreter: Vogel, Georg

(56) Entgegenhaltungen:
- CA-A- 1 177 109
- DE-C- 3 344 598
- DE-U- 8 703 617

## Beschreibung

Die Erfindung betrifft einen Schaltschrank mit einem aus Rahmenschenkeln gebildeten Rahmengestell, das mittels einer Bodenwand, Deckwand und zwei Seitenwänden verschlossen ist und dessen offene Seiten mittels einer Schranktür und einer Rückwand oder mittels zweier Schranktüren verschließbar sind, wobei die Rahmenschenkel ein Hohlprofil bilden, das an den zwei senkrecht zueinander stehenden und dem Schrankinnenraum zugekehrten Rahmenschenkelseiten mit gleichen Lochreihen versehen ist und an einer zur Schrankaußenseite gekehrten Rahmenschenkelseite einen abstehenden Dichtungssteg aufweist.

Ein Schaltschrank dieser Art ist aus der DE-PS 33 44 598 bekannt. Dieses Rahmengstell des Schaltschrankes hat den Vorteil, daß im Schrankinnenraum Anbaumöglichkeiten nach allen Richtungen geschaffen sind und daß an das Rahmengestell die Bodenwand, die Deckwand, die Seitenwände, die Rückwand und Schranktüren dicht abschließend angebracht werden können. Das Rahmengestell des Schaltschrankes ist aus zwölf Rahmenschenkeln zusammengesetzt, so daß der Teile- und Montageaufwand für den Schaltschrank doch ganz beachtlich ist.

Es ist Aufgabe der Erfindung, den Schaltschrank der eingangs erwähnten Art so zu gestalten, daß unter Beibehaltung der universellen Anbaumöglichkeit am Rahmengestell der Teile- und der Montageaufwand beachtlich reduziert werden.

Diese Aufgabe wird nach der Erfindung dadurch gelöst, daß zumindest ein Teil der Rahmenschenkel durch mehrfaches Abkanten einer Platte einstückig an der Bodenwand, der Deckwand und/oder den Seitenwänden angebracht sind, wobei die Abkantung einen ersten Abschnitt aufweist, der senkrecht zur Innenseite der Platte steht und am Ende in einen zweiten Abschnitt übergeht, der am ersten Abschnitt parallel zur Platte nach außen abgekantet ist, wobei das Ende des zweiten Abschnittes in einen dritten Abschnitt übergeht, der sich auf dem zweiten Abschnitt aufliegend über den ersten Abschnitt hinaus verlängert ist und in diesem Bereich mit einer Lochreihe versehen ist, und wobei am Ende des dritten Abschnittes senkrecht zur Innenseite der Platte hin ein vierter Abschnitt abgekantet ist, der wie der dritte Abschnitt eine Lochreihe trägt. Jeder an der Bodenwand, der Deckwand oder an den Seitenwänden abgekantete Rahmenschenkel reduziert den Teile- und Montageaufwand. Die Abkantungen der Rahmenschenkel bilden ein Hohlprofil, wobei zwei Abschnitte wie bei dem bekannten Rahmengestell mit identischen Lochreihen versehen sind und die universelle Verbaubarkeit gewährleisten. Dabei ist vorgesehen, daß die Lochreihen in dem dritten und vierten Abschnitt der Abkantung denselben Abstand zu der Kante aufweisen, die durch den Übergang vom dritten Abschnitt zum vierten Abschnitt gebildet ist.

Eine Erhöhung der Stabilität der so abgekanteten Rahmenschenkel wird auf einfache Weise dadurch erreicht, daß der vierte Abschnitt der Abkantung am Ende mittels eines zum ersten Abschnitt senkrecht eingebogenen fünften Abschnitt versteift ist.

Ein geschlossenes Hohlprofil bilden die abgekanteten Rahmenschenkel dadurch, daß sich der fünfte Abschnitt bis zum ersten Abschnitt erstreckt und dort parallel zum ersten Abschnitt abgekantet mit einem sechsten Abschnitt der Abkantung anliegt und mit dem Abschnitt verbunden ist, wobei aus Gründen der Zugänglichkeit für den Verbindungsvorgang vorgesehen ist, daß der sechste Abschnitt am Ende des fünften Abschnittes zur Innenseite der Platte hin abgekantet ist.

Ein geschlossenes Hohlprofil für die abgekanteten Rahmenschenkel ergibt sich auch dadurch, daß sich der vierte Abschnitt bis zur Innenseite der Platte erstreckt und am Ende mittels eines fünften Abschnittes abgekantet ist, der parallel zur Platte gerichtet ist und an deren Innenseite anliegt und mit dieser verbunden ist, wobei aus Gründen der Zugänglichkeit für den Verbindungsvorgang vorgesehen ist, daß der fünfte Abschnitt auf die dem ersten Abschnitt abgekehrte Seite des vierten Abschnittes abgekantet ist.

Alle Rahmenschenkel des Rahmengestelles lassen sich dadurch einstückig mit der Bodenwand, der Deckwand und den beiden Seitenwänden herstellen, wenn nach einer Ausgestaltung vorgesehen ist, daß an der Bodenwand und der Deckwand nur an den den offenen Seiten zugekehrten Kanten Rahmenschenkel abgekantet sind, während an allen Kanten der Seitenwände Rahmenschenkel abgekantet sind.

Da die Bodenwand, die Deckwand und die beiden Seitenwände im Bereich der aufeinanderstoßenden Kanten vorzugsweise miteinander verschweißt werden, kann das Rahmengestell dadurch vereinfacht werden, daß sich bei den horizontalen Rahmenschenkeln der Seitenwände an den ersten Abschnitt der Abkantung gleich die dritten und vierten Abschnitte anschließen und daß an den zugekehrten Kanten der Bodenwand und der Deckwand ein senkrecht nach der Innenseite abgekanteter Rand angebracht ist.

Die Aufteilung der abgekanteten Rahmenschenkel kann nach einer weiteren Ausgestaltung auch so vorgenommen werden, daß an der Bodenwand und der Deckwand an allen Kanten Rahmenschenkel abgekantet sind, während an den Seitenwänden nur an den vertikalen Kanten Rahmenschenkel abgekantet sind. Da die Bodenwand, die Deckwand und die beiden Seitenwände auch bei dieser Aufteilung der Rahmenschenkel im Bereich der aufeinanderstoßenden Kanten vorzugsweise miteinander verschweißt werden, kann das Rahmengestell dadurch vereinfacht werden, daß die den Seitenwänden zugekehrten Kanten der Bodenwand und der Deckwand einen abgekanteten Rahmenschenkel aufweisen, der nur aus einem dritten Abschnitt und einem vierten Abschnitt besteht, wobei der dritte Abschnitt senkrecht an der Platte abgekantet ist und der vierte Abschnitt parallel zur Platte senkrecht nach außen am dritten Abschnitt absteht, und daß an den zugekehrten Kanten der Seitenwände ein senkrecht abgekanteter Rand angebracht ist.

Eine weitere Ausgestaltung, die nur vier getrennte Rahmenschenkel erfordert, ist dadurch gekennzeichnet, daß an allen Kanten der Seitenwände Rahmenschenkel abgekantet sind, und daß die Bodenwand und die Deckwand im Bereich der offenen Seiten mit Rahmenschenkeln verbunden sind, die als Abschnitte eines Hohlprofils ausgebildet sind. Die Bodenwand und die Deckwand ist dabei boxartig ausgebildet und weist senkrecht abgekantete Ränder auf. Die Bodenwand und die Deckwand wird mit den zugekehrten Rahmenschenkeln der Seitenwände und den getrennten Rahmenschenkeln verbunden. In jedem Fall bilden alle Rahmenschenkel - ob an der Bodenwand, der Deckwand und den Seitenwänden abgekantet oder als Abschnitt eines Hohlprofils ausgebildet - ein Rahmengestell, das in bekannter Weise mittels Eckverbinder miteinander verbunden oder direkt miteinander verschweißt ist.

Damit die Rahmenschenkel in den Ecken des Schaltschrankes das Rahmengestell vervollständigen, ist vorgesehen, daß die einer Ecke zugekehrten Rahmenschenkel aufeinanderstoßen und miteinander verbunden, vorzugsweise verschweißt sind.

Der Teile- und Montageaufwand für einen Schaltschrank läßt sich dadurch noch einmal beachtlich reduzieren, wenn nach einer Weiterbildung vorgesehen ist, daß die beiden Seitenwände und die Deckwand aus einem Zuschnitt zu einem U-förmigen Gehäuseteil gebogen sind, daß an den den offenen Seiten zugekehrten Kanten die Rahmenschenkel abgekantet sind, daß die dem Boden zugekehrten Kanten des Gehäuseteils senkrecht abgekantete Ränder aufweisen und daß der offene Boden des Schaltschrankes mittels eines aus vier Hohlprofilabschnitten gebildeten Rahmens abgeschlossen ist, der mit den Rändern der Seitenwände verbunden ist.

Soll der Boden des Schaltschrankes verschlossen sein, dann kann die Ausgestaltung so abgewandelt sein, daß der Rahmen Teil einer Bodenplatte ist, an der die Rahmenschenkel abgekantet sind. Die Bodenwand kann dabei durchaus Durchbrüche aufweisen, durch die Kabel in das Schrankinnere eingeführt werden.

Die Erfindung wird anhand von verschiedenen, in den Zeichnungen dargestellten Ausführungsbeispielen näher erläutert. Es zeigt:
Fig. 1 ein erstes Ausführungsbeispiel für die an einer Platte abgekanteten, als Hohlprofil ausgebildeten Rahmenschenkel,
Fig. 2 ein zweites Ausführungsbeispiel für die abgekanteten Rahmenschenkel,
Fig. 3 ein drittes Ausführungsbeispiel für die abgekanteten Rahmenschenkel,
Fig. 4 ein viertes Ausführungsbeispiel für die abgekanteten Rahmenschenkel,
Fig. 5 die Bodenwand, die Deckwand und die beiden Seitenwände, die nach der Verbindung miteinander einen vorne und hinten offenen Schrankkorpus eines Schaltschrankes bilden,
Fig. 6 in Einzelheiten in einem Eckbereich die Abkantungen einer Seitenwand und der Bodenwand für den Schaltschrank nach Fig. 5,
Fig. 7 eine Abwandlung für die Bodenwand eines Schaltschrankes nach Fig. 5 anhand der Einzelheiten in einem Eckbereich,
Fig. 8 in Einzelheiten in einem Eckbereich die Abkantungen der vertikalen Kanten der Seitenwand und aller Kanten der Bodenwand für eine alternative Ausgestaltung des Schaltschrankes,
Fig. 9 die zusammengesetzte Ecke des Schaltschrankes mit der Seitenwand und der Bodenwand nach Fig. 8,
Fig. 10 in Einzelheiten den Eckbereich eines aus zwei Seitenwänden und der Deckwand bestehenden Gehäuseteils und die angrenzenden getrennten Rahmenschenkel eines den Boden abschließenden Rahmens und
Fig. 11 die zusammengesetzten Eckbereiche des Schaltschrankes nach Fig. 10.

Der Teile- und Montageaufwand bei dem Schaltschrank wird dadurch reduziert, daß zumindest ein Teil der Rahmenschenkel des Rahmengestelles an der Bodenwand, der Deckwand und/oder den beiden Seitenwänden des Schrankkorpus abgekantet sind. Die mehrfache Abkantung ist dabei so ausgebildet, daß zwei im rechten Winkel zueinander stehende Abschnitte der Abkantungen mit Lochreihen versehen sind und daß nach außen abstehend die für den dichten Abschluß der offenen Seiten erforderlichen Dichtstege gebildet werden.

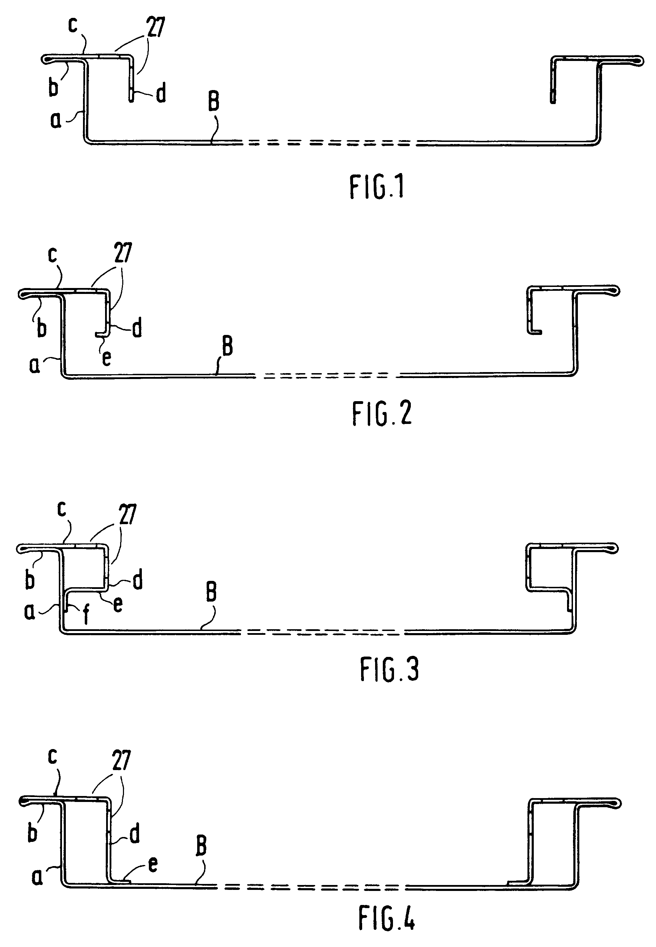

Anhand der Fig. 1 bis 4 werden vier Ausführungsbeispiele für die abgekanteten Rahmenschenkel gezeigt. Die Platte B kann dabei die Bodenwand, die Deckwand oder eine Seitenwand sein. Bei allen Ausführungsbeispielen ist ein erster Abschnitt a senkrecht an der Innenseite der Platte B abgekantet. Das Ende des ersten Abschnittes a geht in den zweiten Abschnitt b über, der an der Außenseite des ersten Abschnittes a parallel zur Platte B absteht und zusammen mit dem anschließenden dritten Abschnitt c den Dichtungssteg bilden. Der dritte Abschnitt c liegt auf dem zweiten Abschnitt b auf und ist über den ersten Abschnitt a hinaus verlängert. Am Ende des dritten Abschnittes c ist der vierte Abschnitt d senkrecht zur Innenseite der Platte B hin abgekantet. Der dritte Abschnitt c und der vierte Abschnitt d tragen die Lochreihen 27, die identisch ausgebildet und aufeinander ausgerichtet sind. Der Abstand der Lochreihen 27 von der Kante, die durch den Übergang vom dritten Abschnitt c zum vierten Abschnitt d gebildet ist.

Wie die Fig. 2 zeigt, kann der Rahmenschenkel und insbesondere der vierte Abschnitt d der Abkantung durch einen fünften Abschnitt e versteift werden, der am Ende des vierten Abschnittes e senkrecht zum ersten Abschnitt a hin abgekantet ist.

Der abgekantete Rahmenschenkel kann ein geschlossenes Hohlprofil bilden, wie die Fig. 3 zeigt, wenn der fünfte Abschnitt e bis zum ersten Abschnitt a hin verlängert ist und dort in einen zum ersten Abschnitt a parallelen sechsten Abschnitt f übergeht, der am ersten Abschnitt a anliegt und mit diesem verbunden, insbesondere verschweißt sein kann. Dabei ist der sechste Abschnitt f in Richtung zur Innenseite der Platte B hin abgekantet, um für den Verbindungsvorgang besser zugänglich zu sein.

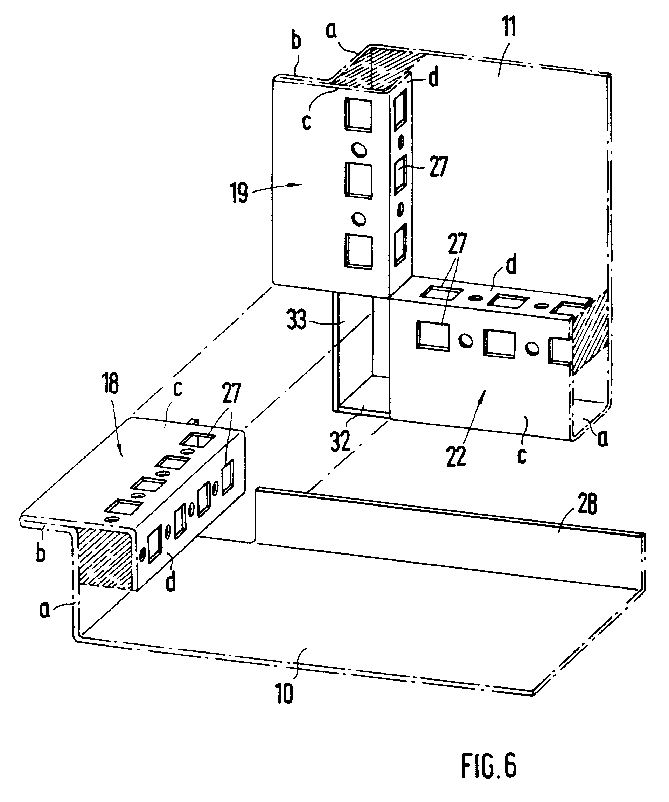

Schließlich zeigt die Fig. 6 ein weiteres Ausführungsbeispiel für ein geschlossenes Hohlprofil des abgekanteten Rahmenschenkels. Der vierte Abschnitt d erstreckt sich dabei bis zur Innenseite der Platte B und geht dort in den senkrecht abgekanteten fünften Abschnitt e über, der in Richtung vom ersten Abschnitt a abgekehrt abgekantet ist. Der fünfte Abschnitt e läßt sich dann leicht mit der Innenseite der Platte B verbinden.

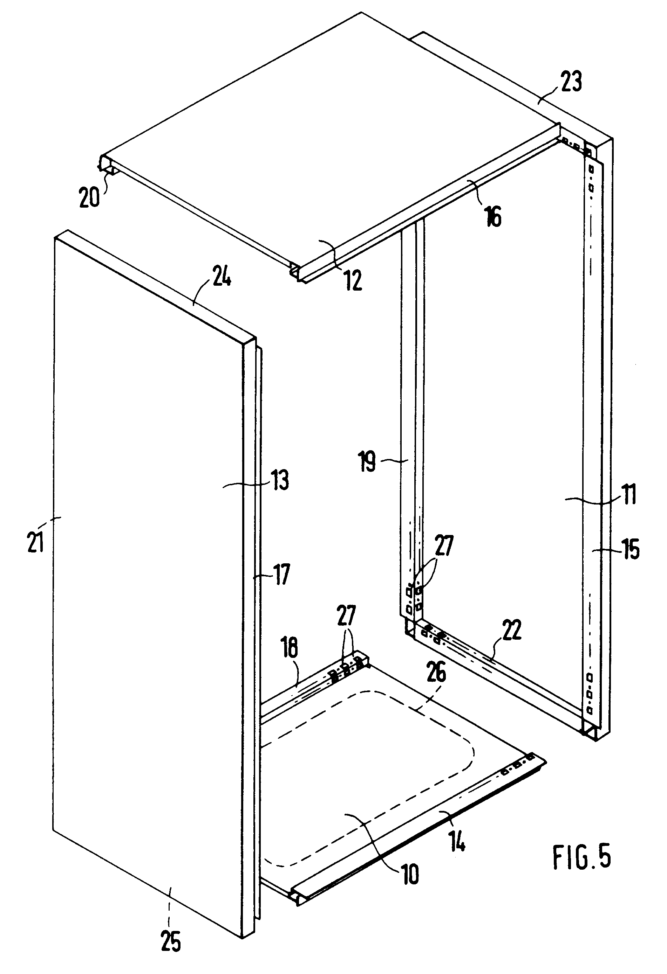

Die Fig. 5 zeigt die Bodenwand 10, die Deckwand 12 und die beiden Seitenwände 11 und 13, aus denen der Schrankkorpus des Schaltschrankes zusammengesetzt wird. Am Schrankkorpus bleiben die vordere und die hintere Seite offen. Das Rahmengestell wird aus den Rahmenschenkeln 14 bis 25 gebildet, die alle an zugeordneten Kanten der Bodenwand 10, der Deckwand 12 und den Seitenwänden 11 und 13 durch mehrfaches Abkanten nach einer Art, wie es in Fig. 1 bis Fig. 4 gezeigt ist. Die Abschnitte c und d mit den Lochreihen 27 sind nach dem Zusammenbau des Schrankkorpus dem Schrankinnenraum zugekehrt. Bei dem Ausführungsbeispiel nach Fig. 5 sind an den den offenen Seiten des Schrankkorpus zugekehrten Kanten der Bodenwand 10 die Rahmenschenkel 14 und 18 abgekantet, während an der Deckwand 12 die Rahmenschenkel 16 und 20 einstückig abgekantet sind. Die beiden Seitenwände 11 und 13 sind an allen Kanten mit abgekanteten Rahmenschenkeln versehen, wie die Rahmenschenkel 15,19, 22 und 23 bzw. 17,21, 24 und 25 zeigen.

Die Bodenwand 10, die Deckwand 12 und die Seitenwände 11 und 13 werden im Bereich der aufeinanderstoßenden Kanten miteinander verbunden, insbesondere verschweißt. In der Bodenwand 10 kann ein Durchbruch 26 eingebracht werden, durch den Kabel in den Schaltschrank eingeführt werden können.

In Fig. 6 sind Einzelheiten der Seitenwand 11 und der Bodenwand 10 dargestellt, die nach dem Zusammenbau eine Ecke des Schrankkorpus bilden. Die vertikale Kante der Seitenwand 11 trägt einen abgekanteten Rahmenschenkel 19, wie Fig. 1 zeigt. Dieser Rahmenschenkel 19 endet vor dem horizontalen Rahmenschenkel 22, bei dem der erste Abschnitt a sofort in den dritten Abschnitt c mit einer Lochreihe 27 übergeht. Der vierte Abschnitt d mit einer Lochreihe 27 schließt sich senkrecht zur Innenseite der Seitenwand 11 stehend an. Im Eckbereich sind die ersten Abschnitte a der Rahmenschenkel 19 und 22 als abgekantete Ränder 32 und 33 weitergeführt. Damit die Bodenwand 10 leicht mit der zugekehrten Kante der Seitenwand 11 verbunden werden kann, ist an dieser Kante der Rand 28 nach innen abgekantet. Die Fig. 6 zeigt die Verbindung von der Bodenwand 10 und der Seitenwand 11 im Bereich der unteren hinteren Ecke des Schrankkorpus. Die übrigen Eckbereiche zwischen der Bodenwand 10 und den Seitenwänden 11 und 13 sind ähnlich ausgelegt und auch die Verbindungen zwischen der Deckwand 12 und den Seitenwänden 11 und 13 sind ähnlich.

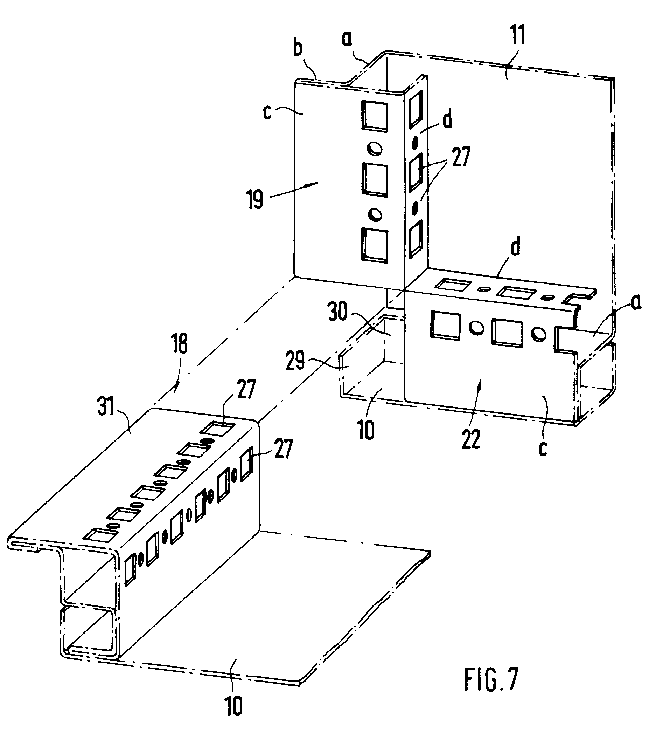

Wie Fig. 7 zeigt, kann der Schrankkorpus auch mit anders gestalteter Bodenwand 10 und Deckwand 12 zusammengesetzt werden. Die Seitenwände 11 und 13 sind wie bei dem Schrankkorpus nach Fig. 5. Die Bodenwand 10 ist boxartig ausgebildet und weist die abgekanteten Ränder 29 und 30 auf. Die als Hohlprofilabschnitte 31 ausgebildeten Rahmenschenkel 14 und 18 vervollständigen das Rahmengestell im Bereich der Bodenwand 10.

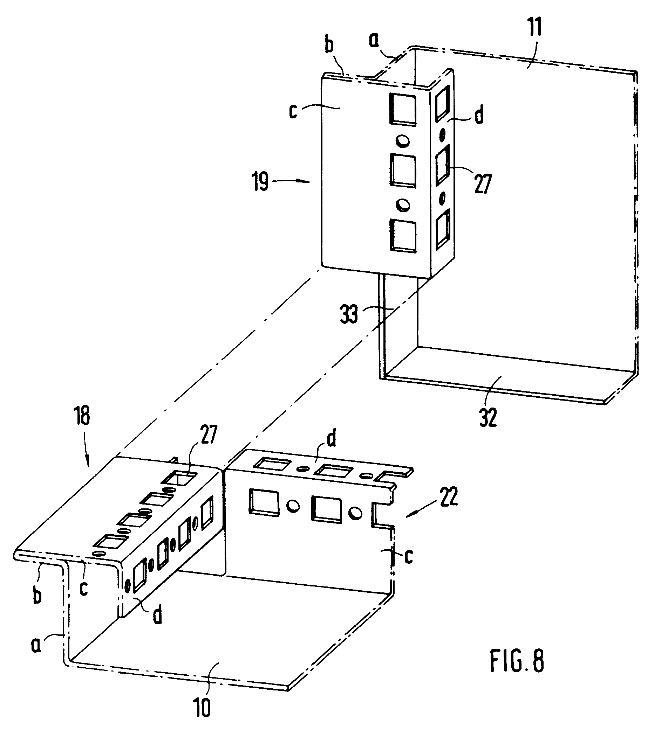

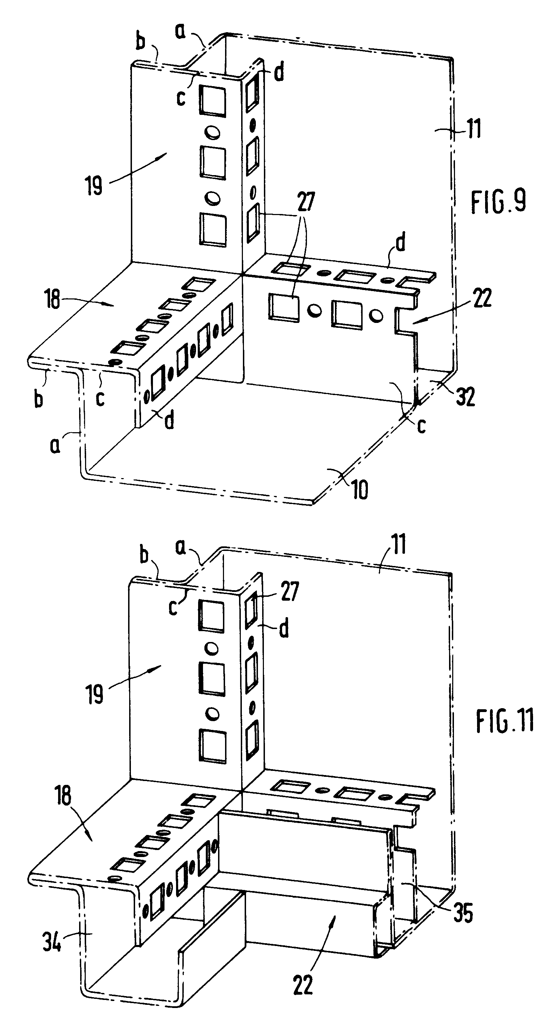

In Fig. 8 ist ein weiteres Ausführungsbeispiel für den Schrankkorpus des Schaltschrankes gezeigt. Die Bodenwand 10 und die Deckwand 12 tragen an allen Kanten abgekantete Rahmenschenkel 14, 18, 22 und 25 bzw. 16, 20, 23 und 24. Die Seitenwände 11 und 13 tragen nur an den vertikalen Kanten abgekantete Rahmenschenkel 15 und 19 bzw. 17 und 21. Wie der in Fig. 8 gezeigte Eckbereich der Seitenwand 11 und der Bodenwand 10 erkennen läßt, sind die Rahmenschenkel an den vertikalen Kanten der Seitenwände 11 und 13 entsprechend Fig. 1 bis Fig. 4 abgekantet. Die Rahmenschenkel enden dabei vor der Ecke, um Platz für die Rahmenschenkel der Bodenwand 10 zu schaffen. Der erste Abschnitt a der Rahmenschenkel ist als Rand 33 bis zur Ecke weitergeführt. Die horizontalen Kanten der Seitenwände 11 und 13 weisen den abgekanteten Rand 32 auf. Die Rahmenschenkel 22 und 25 der Bodenwand, die dem Rand 32 der Seitenwände 11 und 13 zugekehrt sind, weisen nur die dritten und vierten Abschnitte c und d der Abkantung mit den Lochreihen 27 auf. Nach dem Zusammenbau bilden die Rahmenschenkel das komplette Rahmengestell, wie die in der Ecke nach Fig. 9 zusammenlaufenden Rahmenschenkel 18, 19 und 22 zeigen. Dabei werden an allen Stoßstellen vorzugsweise Schweißnähte angebracht, damit die Bodenwand 10, die Deckwand 12 und die Seitenwände 11 und 13 zu dem Schrankkorpus verbunden sind.

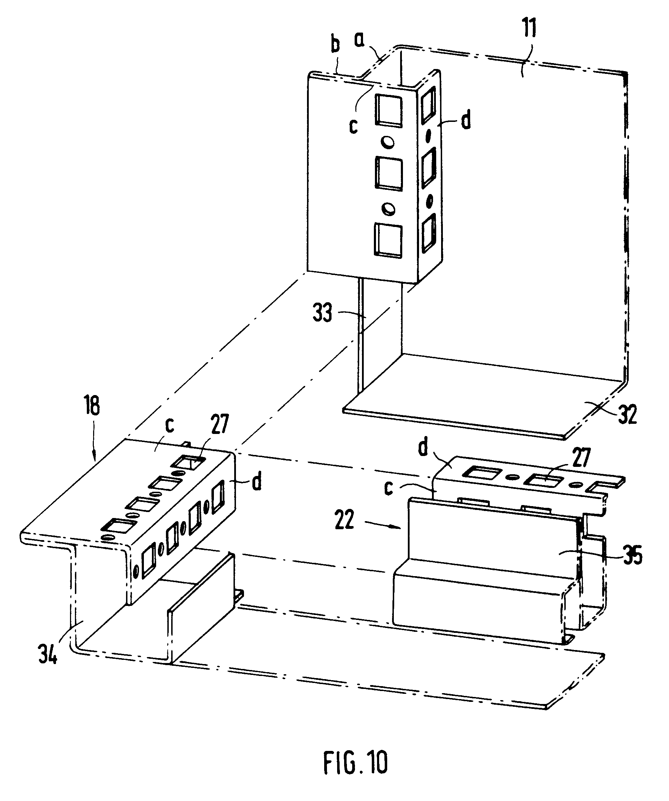

Fig. 10 und Fig. 11 zeigen ein weiteres Ausführungsbeispiel, wobei die Seitenwände 11 und 13 den Seitenwänden 11 und 13 der Fig. 8 entsprechen können. Die Seitenwände 11 und 13 können aber auch mit der Deckwand 12 aus einem Zuschnitt gebogen werden und ein U-förmiges Gehäuseteil bilden, bei dem an den den offenen Seiten des Schrankkorpus zugekehrten Kanten Rahmenschenkel nach Fig. 1 bis Fig. 4 abgekantet sind.

Zur Vervollständigung des Rahmengestelles schließt ein Rahmen aus vier Hohlprofilabschnitten 34 bzw. 35 den Boden des Schrankkorpus ab. Die Rahmenschenkel weisen Abschnitte c und d mit Lochreihen 27 auf und können Abkantungen zur Abstützung einer Bodenplatte haben. An den Abbiegungen zwischen der Deckwand 12 und den Seitenwänden 11 und 13 werden innen als Hohlprofilabschnitte ausgebildete Rahmenschenkel eingeschweißt, so daß auch im Bereich der Deckwand 12 die universelle Verbaubarkeit erhalten bleibt.

## Patentansprüche

1. Schaltschrank mit einem aus Rahmenschenkeln gebildeten Rahmengestell, das mittels einer Bodenwand, Deckwand und zwei Seitenwänden verschlossen ist und dessen offene Seiten mittels einer Schranktür und einer Rückwand oder mittels zweier Schranktüren verschließbar sind, wobei die Rahmenschenkel ein Hohlprofil bilden, das an den zwei senkrecht zueinander stehenden und dem Schrankinnenraum zugekehrten Rahmenschenkelseiten mit gleichen Lochreihen versehen ist und an einer zur Schrankaußenseite gekehrten Rahmenschenkelseite einen abstehenden Dichtungssteg aufweist,
dadurch gekennzeichnet,
daß zumindest ein Teil der Rahmenschenkel (14 bis 25) durch mehrfaches Abkanten einer Platte (B) einstückig an der Bodenwand (10), der Deckwand (12) und/oder den Seitenwänden (11,13) angebracht ist, wobei die Abkantung einen ersten Abschnitt (a) aufweist, der senkrecht zur Innenseite der Platte (B) steht und am Ende in einen zweiten Abschnitt (b) übergeht, der am ersten Abschnitt (a) parallel zur Platte (B) nach außen abgekantet ist, wobei das Ende des zweiten Abschnittes (b) in einen dritten Abschnitt (c) übergeht, der sich auf dem zweiten Abschnitt (b) aufliegend über den ersten Abschnitt (a) hinaus verlängert ist und in diesem Bereich mit einer Lochreihe (27) versehen ist, und wobei am Ende des dritten Abschnittes (c) senkrecht zur Innenseite der Platte (B) hin ein vierter Abschnitt (d) abgekantet ist, der wie der dritte Abschnitt (c) eine Lochreihe (27) trägt.

2. Schaltschrank nach Anspruch 1,
dadurch gekennzeichnet,
daß die Lochreihen (27) in dem dritten und vierten Abschnitt (c und d) der Abkantung denselben Abstand zu der Kante aufweisen, die durch den Übergang vom dritten Abschnitt (c) zum vierten Abschnitt (d) gebildet ist.

3. Schaltschrank nach Anspruch 1 oder 2,
dadurch gekennzeichnet,
daß der vierte Abschnitt (d) der Abkantung am Ende mittels eines zum ersten Abschnitt (a) senkrecht eingebogenen fünften Abschnitt (e) versteift ist.

4. Schaltschrank nach Anspruch 3,
dadurch gekennzeichnet,
daß sich der fünfte Abschnitt (e) bis zum ersten Abschnitt (a) erstreckt und dort parallel zum ersten Abschnitt (a) abgekantet mit einem sechsten Abschnitt (f) der Abkantung anliegt und mit dem Abschnitt (a) verbunden ist.

5. Schaltschrank nach Anspruch 4,
dadurch gekennzeichnet,
daß der sechste Abschnitt (f) am Ende des fünften Abschnittes (e) zur Innenseite der Platte (P) hin abgekantet ist.

6. Schaltschrank nach Anspruch 1 oder 2,
dadurch gekennzeichnet,
daß sich der vierte Abschnitt (d) bis zur Innenseite der Platte (B) erstreckt und am Ende mittels eines fünften Abschnittes (e) abgekantet ist, der parallel zur Platte (B) gerichtet ist und an deren Innenseite anliegt und mit dieser verbunden ist.

7. Schaltschrank nach Anspruch 6,
dadurch gekennzeichnet,
daß der fünfte Abschnitt (e) auf die dem ersten Abschnitt (a) abgekehrte Seite des vierten Abschnittes (d) abgekantet ist.

8. Schaltschrank nach einem der Ansprüche 1 bis 7,
dadurch gekennzeichnet,
daß an der Bodenwand (10) und der Deckwand (12) nur an den den offenen Seiten zugekehrten Kanten Rahmenschenkel (14,18; 16,20) abgekantet sind, während an allen Kanten der Seitenwände (11,13) Rahmenschenkel (15,19, 22,23; 17,21, 24,25) abgekantet sind (Fig. 5).

9. Schaltschrank nach Anspruch 8,
dadurch gekennzeichnet,
daß sich bei den horizontalen Rahmenschenkeln (22,23, 24,25) der Seitenwände (11,13) an den ersten Abschnitt (a) der Abkantung gleich die dritten und vierten Abschnitte (e und d) anschließen und
daß an den zugekehrten Kanten der Bodenwand (10) und der Deckwand (12) ein senkrecht nach der Innenseite abgekanteter Rand (28) angebracht ist (Fig. 6).

10. Schaltschrank nach einem der Ansprüche 1 bis 7,
dadurch gekennzeichnet,
daß an der Bodenwand (10) und der Deckwand (12) an allen Kanten Rahmenschenkel (14,18, 22,25; 16,20, 23,24) abgekantet sind, während an den Seitenwänden (11,13) nur an den vertikalen Kanten Rahmenschenkel (15,19; 17,21) abgekantet sind (Fig. 8).

11. Schaltschrank nach Anspruch 10,
dadurch gekennzeichnet,
daß die den Seitenwänden (11,13) zugekehrten Kanten der Bodenwand (10) und der Deckwand (12) einen abgekanteten Rahmenschenkel (22 bis 25) aufweisen, der nur aus einem dritten Abschnitt (c) und einem vierten Abschnitt (d) besteht, wobei der dritte Abschnitt (c) senkrecht an der Platte (B) abgekantet ist und der vierte Abschnitt (d) parallel zur Platte (B) senkrecht nach außen am dritten Abschnitt (c) absteht, und
daß an den zugekehrten Kanten der Seitenwände (11,13) ein senkrecht abgekanteter Rand (32) angebracht ist (Fig. 8).

12. Schaltschrank nach Anspruch 1 bis 7,
dadurch gekennzeichnet,
daß an allen Kanten der Seitenwände (11,13) Rahmenschenkel (15,17, 19,21; 22,23, 24,25) abgekantet sind, und
daß die Bodenwand (10) und die Deckwand (12) im Bereich der offenen Seiten mit Rahmenschenkeln (14,16, 18,20) verbunden sind, die als Abschnitte (31) eines Hohlprofils ausgebildet sind (Fig. 7).

13. Schaltschrank nach Anspruch 12,
dadurch gekennzeichnet,
daß die Bodenwand (10) und die Deckwand (12) boxartig ausgebildet ist und senkrecht abgekantete Ränder (29,30) aufweist.

14. Schaltschrank nach einem der Ansprüche 1 bis 13,
dadurch gekennzeichnet,
daß die einer Ecke zugekehrten Rahmenschenkel (14,15,22; 15,16,23; 16,17,24; 14,17,25; 18,19,22; 19,20,23; 20,21,24; 18,21,24) aufeinander stoßen und miteinander verbunden, vorzugsweise verschweißt sind.

15. Schaltschrank nach einem der Ansprüche 1 bis 7,
dadurch gekennzeichnet,
daß die beiden Seitenwände (11,13) und die Deckwand (12) aus einem Zuschnitt zu einem U-förmigen Gehäuseteil gebogen sind,
daß an den den offenen Seiten zugekehrten Kanten die Rahmenschenkel (15,16,17; 19,20,21) abgekantet sind,
daß die dem Boden zugekehrten Kanten des Gehäuseteils senkrecht abgekantete Ränder (32) aufweisen und
daß der offene Boden des Schaltschrankes mittels eines aus vier Hohlprofilabschnitten (34,35) gebildeten Rahmens abgeschlossen ist, der mit den Rändern (32) der Seitenwände (11,13) verbunden ist.

16. Schaltschrank nach Anspruch 15,
dadurch gekennzeichnet,
daß der Rahmen Teil einer Bodenplatte (10) ist, an der die Rahmenschenkel (14,18, 22,25) abgekantet sind.

## Claims

1. Switchgear cabinet having a frame, which is formed from frame members and is closed by means of a bottom wall, a top wall and two lateral walls, the open ends of said frame being closable by means of a cabinet door and a rear wall or by means of two cabinet doors, the frame members comprising a hollow profile, which is provided with identical rows of holes in the two frame member ends extending vertically relative to one another and facing the cabinet interior and which has a protruding sealing web at one frame member end facing the cabinet exterior, characterised in that at least some of the frame members (14 to 25) are integrally formed on the bottom wall (10), the top wall (12) and/or the lateral walls (11, 13) by multiple folding of a plate (B), the folding having a first portion (a), which extends vertically relative to the internal surface of the plate (B) and, at its end, passes into a second portion (b), which second portion is outwardly folded from the first portion (a) parallel to the plate (B), the end of the second portion (b) passing into a third portion (c) overlying the second portion (b), which extends beyond the plane of the first portion (a) and is provided with a row of holes (27) in this region, and a fourth portion (d) being folded, at the end of the third portion (c), vertically towards the internal surface of the plate (B) and having a row of holes (27) corresponding to those of the third portion (c).

2. Switchgear cabinet according to claim 1, characterised in that the rows of holes (27) in the third and fourth portions (c and d) of the folding have the same spacing from the corner, which is formed by the transition from the third portion (c) to the fourth portion (d).

3. Switchgear cabinet according to claim 1 or 2, characterised in that the fourth portion (d) of the folding is reinforced at the end by means of a fifth portion (e), which is bent vertically inwardly towards the first portion (a).

4. Switchgear cabinet according to claim 3, characterised in that the fifth portion (e) extends to the first portion (a), is folded there parallel to the first portion (a), and abuts, by means of a sixth portion (f) of the folding, which is connected to the portion (a).

5. Switchgear cabinet according to claim 4, characterised in that the sixth portion (f) is folded at the end of the fifth portion (e) towards the internal surface of the plate (B).

6. Switchgear cabinet according to claim 1 or 2, characterised in that the fourth portion (d) extends to the internal surface of the plate (B) and is folded at the end by means of a fifth portion (e), which is orientated parallel to the plate (B), abuts against the internal surface thereof and is connected to said surface.

7. Switchgear cabinet according to claim 6, characterised in that the fifth portion (e) is folded at the end of the fourth portion (d) remote from the first portion (a).

8. Switchgear cabinet according to one of claims 1 to 7, characterised in that frame members (14,18; 16,20) are folded at the bottom wall (10) and the top wall (12) only along the edges facing the open ends, while frame members (15,19, 22,23; 17,21, 24,25) are folded along all of the edges of the lateral walls (11, 13) (Fig. 5).

9. Switchgear cabinet according to claim 8, characterised in that, when the frame members (22,23, 24,25) of the lateral walls (11,13) are horizontal, the third and fourth portions (e and d) communicate identically with the first portion (a) of the folding, and in that an edge (28), which is folded vertically towards the internal surface, is attached to the facing edges of the bottom wall (10) and the top wall (12) (Fig. 6).

10. Switchgear cabinet according to one of claims 1 to 7, characterised in that frame members (14,18, 22,25; 16,20, 23,24) are folded along all of the edges of the bottom wall (10) and the top wall (12), while frame members (15,19; 17,21) are folded only along the vertical edges of the lateral walls (11,13) (Fig. 8).

11. Switchgear cabinet according to claim 10, characterised in that the edges of the bottom wall (10) and the top wall (12) facing the lateral walls (11,13) have a folded frame member (22 to 25) which only includes a third portion (c) and a fourth portion (d), the third portion (c) being folded vertically at the plate (B), and the fourth portion (d) protruding vertically outwardly at the third portion (c) parallel to the plate (B), and in that a vertically folded edge (32) is attached to the facing edges of the lateral walls (11,13) (Fig. 8).

12. Switchgear cabinet according to claims 1 to 7, characterised in that frame members (15,17, 19,21; 22,23, 24,25) are folded along all of the edges of the lateral walls (11,13), and in that, in the region of the open ends, the bottom wall (10) and the top wall (12) are connected to frame members (14,16, 18,20) which are in the form of portions (31) of a hollow profile (Fig. 7).

13. Switchgear cabinet according to claim 12, characterised in that the bottom wall (10) and the top wall (12) are box-shaped and have vertically folded edges (29,30).

14. Switchgear cabinet according to one of claims 1 to 13, characterised in that the frame members (14,15,22; 15,16,23; 16,17,24; 14,17,25; 18,19,22; 19,20,23; 20,21,24; 18,21,24), which face a corner, butt against one another and are interconnected, preferably welded together.

15. Switchgear cabinet according to one of claims 1 to 7, characterised in that the two lateral walls (11,13) and the top wall (12) are bent from a blank to form a U-shaped housing member, in that the frame members (15,16,17; 19,20,21) are folded along the edges facing the open ends, in that the edges of the housing member facing the base have vertically folded edges (32), and in that the open base of the switchgear cabinet is closed by means of a frame, which is formed from four hollow profile portions (34,35) and is connected to the ends (32) of the lateral walls (11,13).

16. Switchgear cabinet according to claim 15, characterised in that the frame is part of a bottom plate (10), on which the frame members (14,18, 22,25) are folded.

## Revendications

1. Armoire électrique avec un châssis-cadre composé d'ailes d'encadrement, châssis-cadre qui est fermé au moyen d'une paroi de base, d'une paroi de recouvrement et de deux parois latérales et dont les côtés ouverts peuvent être fermés au moyen d'une porte d'armoire et d'une paroi arrière ou au moyen de deux portes d'armoire, les ailes d'encadrement constituant un profilé creux, lequel présente des rangées identiques de perforations sur les deux côtés perpendiculaires l'un à l'autre et orientés vers l'intérieur de l'armoire et lequel présente une nervure d'étanchéité en protubérance sur un côté d'aile d'encadrement orienté vers l'extérieur de l'armoire,
caractérisée
en ce qu'au moins une partie des ailes d'encadrement (14 à 25) est par pliage multiple d'une plaque (B) constituée par une seule pièce fixée à la paroi de base (10), à la paroi de recouvrement (12) et/ou aux parois latérales (11,13), la plaque pliée présentant un premier tronçon (a) qui est perpendiculaire à la face intérieure de la plaque (B), le tronçon (a) se terminant par un deuxième tronçon (b), lequel est plié sur le premier tronçon (a) et est dirigé vers l'extérieur parallèlement à la plaque (B), l'extrémité du deuxième tronçon (b) se prolongeant par un troisième tronçon (c), lequel est appliqué sur le deuxième tronçon (b) et se prolonge au-delà du premier tronçon (a) et qui présente dans cette dernière région une rangée de perforations (27), tandis qu'à l'extrémité du troisième tronçon (c) est obtenu par pliage un quatrième tronçon (d) qui est perpendiculaire à la face intérieure de la plaque (B), quatrième tronçon (d) qui, tout comme le troisième tronçon (c), présente une rangée de perforations (27).

2. Armoire électrique suivant la revendication 1,
caractérisée
en ce que les rangées de perforations (27) dans le troisième et dans le quatrième tronçon (c et d) de la plaque pliée présentent la même distance à l'arête qui est formée par le passage du troisième tronçon (c) au quatrième tronçon (d).

3. Armoire électrique suivant la revendication 1 ou 2,
caractérisée
en ce que le quatrième tronçon (d) de la plaque coudée est à son extrémité raidi au moyen d'un cinquième tronçon (e) plié perpendiculairement au premier tronçon (a).

4. Armoire électrique suivant la revendication 3,
caractérisée
en ce que le cinquième tronçon (e) s'étend jusqu'au premier tronçon (a) et y est plié parallèlement au premier tronçon (a) pour constituer un sixième tronçon (f) appliqué au premier tronçon (a) et relié à celui-ci.

5. Armoire électrique suivant la revendication 4,
caractérisée
en ce que le sixième tronçon (f) est à l'extrémité du cinquième tronçon (e), plié en direction de la face intérieure de la plaque (P).

6. Armoire électrique suivant la revendication 1 ou 2,
caractérisée
en ce que le quatrième tronçon (d) s'étend jusqu'à la face intérieure de la plaque (B) et est, à l'extrémité, plié avec formation d'un cinquième tronçon (e), qui est orienté parallèlement à la plaque (B) et est appliqué à la face intérieure de celle-ci et est reliée à celle-ci.

7. Armoire électrique suivant la revendication 6,
caractérisée
en ce que le cinquième tronçon (e) est plié sur le côté du quatrième tronçon (d) qui n'est pas orienté vers le premier tronçon (a).

8. Armoire électrique suivant l'une quelconque des revendications de 1 à 7,
caractérisée
en ce que sur la paroi de base (10) et sur la paroi de recouvrement (12) sont formées par pliage des ailes d'encadrement (14,18; 16,20) sur les seules arêtes orientées vers les côtés ouverts, tandis que sur toutes les arêtes des parois latérales (11, 13) sont formées par pliage des ailes d'encadrement (15,19,22,23; 17,21,24,25) (Fig. 5).

9. Armoire électrique suivant la revendication 8,
caractérisée
en ce que en ce qui concerne les ailes d'encadrement horizontales (22,23,24,25) des parois latérales (11,13), le premier tronçon plié (a) est directement suivi du troisième et du quatrième tronçon (e et d), et
en ce que sur les arêtes qui se font face de la paroi de base (10) et de la paroi de recouvrement (12) est prévu un rebord (28) plié perpendiculairement sur la face intérieure (Fig. 6).

10. Armoire électrique suivant l'une quelconque des revendications de 1 à 7,
caractérisée
sur la paroi de base (10) et sur la paroi de recouvrement (12), des ailes d'encadrement (14,18, 22,25; 16,20, 23,24) sont pliées sur toutes les arêtes, tandis que sur les parois latérales (11,13), des ailes d'encadrement (15,19; 17,21) sont pliées seulement sur les arêtes verticales (Fig. 8).

11. Armoire électrique suivant la revendication 10,
caractérisée
en ce que les arêtes de la paroi de base (10) et de la paroi de recouvrement (12) qui font face aux parois latérales (11,13) présentent une aile d'encadrement (22 à 25) formée par pliage, qui est constituée uniquement d'un troisième tronçon (c) et d'un quatrième tronçon (d), le troisième tronçon (c) étant plié perpendiculairement sur la plaque (B) et le quatrième tronçon (d) faisant protubérance parallèlement à la plaque (B) et perpendiculairement vers l'extérieur sur le troisième tronçon (c), et
en ce que sur les arêtes qui se font face des parois latérales (11,13) est prévu un rebord plié perpendiculairement (Fig. 8).

12. Armoire électrique suivant l'une quelconque des revendications de 1 à 7,
caractérisée
en ce que sur toutes les arêtes des parois latérales (11,13) sont formées par pliage des ailes d'encadrement (15,17,19,21; 22,23,24,25), et
en ce que dans la région des côtés ouverts, la paroi de base (10) et la paroi de recouvrement (12) sont reliées à des ailes d'encadrement (14,16, 18,20) qui ont la forme de tronçons (31) d'un profilé creux (Fig.7).

13. Armoire électrique suivant la revendication 12,
caractérisée
en ce que la paroi de base (10) et la paroi de recouvrement (12) sont du type caisson et présente des rebords (29, 30) pliées perpendiculairement.

14. Armoire électrique suivant l'une quelconque des revendications de 1 à 13,
caractérisée
en ce que les ailes d'encadrement (14,15,22; 15,16,23; 16,17,24; 14,17,25; 18,19,22; 19,20,23; 20,21,24; 18,21,24) dirigées vers un angle butent les unes contre les autres et sont reliées, de préférence par soudage.

15. Armoire électrique suivant l'une quelconque des revendications de 1 à 7,
caractérisée
en ce que les deux parois latérales (11,13) et la paroi de recouvrement (12) sont pliées à partir d'un flan unique pour former un élément de boîtier en forme de U,
en ce que sur les arêtes faisant face aux côtés ouverts sont formées par pliage les ailes d'encadrement (15,16,17; 19,20,21),
en ce que les arêtes de l'élément de boîtier faisant face à la base présentent des rebords (32) pliés perpendiculairement, et
en ce que la base ouverte de l'armoire électrique est fermée par un cadre constitué par quatre tronçons de profilé creux (34,35), cadre qui est relié aux rebords (32) des parois latérales (11,13).

16. Armoire électrique suivant la revendication 15,
caractérisée
en ce que le cadre fait partie d'une plaque de base (10), sur laquelle sont formées par pliage les ailes d'encadrement (14,18, 22,25).
